**Europäisches Patentamt**

**European Patent Office**

**Office européen des brevets**

(19)

(11) Veröffentlichungsnummer : **0 019 591
B1**

(12) # EUROPÄISCHE PATENTSCHRIFT

(45) Veröffentlichungstag der Patentschrift :
**16.02.83**

(21) Anmeldenummer : **80810157.0**

(22) Anmeldetag : **09.05.80**

(51) Int. Cl.³ : **G 04 G   3/02, H 03 L   1/02,
G 04 F   5/06**

(54) **Quarzoszillator mit Temperaturkompensation.**

(30) Priorität : **22.05.79 CH 4783/79**

(43) Veröffentlichungstag der Anmeldung :
**26.11.80 Patentblatt 80/24**

(45) Bekanntmachung des Hinweises auf die Patenterteilung : **16.02.83 Patentblatt 83/07**

(84) Benannte Vertragsstaaten :
**DE FR GB**

(56) Entgegenhaltungen :
**CH A 453 223
GB A 2 004 155
US A 4 071 797
ELECTRONICS LETTERS, Band 11, Nr. 14, 10. Juli 1975, J. BRUNNER : « Widerange temperature compensation by addition of two crystal-resonator frequencies practical results with quartz and LiTaO3 », Seiten 304, 305.
Proceedings of the 32nd Annual Symposium on Frequency Control 31.5.-2.7. 1978, Seiten 403-408.**

(73) Patentinhaber : **SOCIETE SUISSE POUR L'INDUSTRIE HORLOGERE MANAGEMENT SERVICES S.A.
Rue Stämpfli 96
CH-2500 Bienne (CH)**

(72) Erfinder : **Zumsteg, Alphonse
St. Niklausstrasse 24
CH-4500 Soleure (CH)**

(74) Vertreter : **Seehof, Michel et al
c/o AMMANN PATENTANWAELTE AG BERN
Schwarztorstrasse 31
CH-3001 Bern (CH)**

EP 0 019 591 B1

**0 019 591**

## Quarzoszillator mit Temperaturkompensation

Die vorliegende Erfindung bezieht sich auf einen Quarzoszillator mit einer ersten Quarzoszillatorschaltung und einer zweiten Quarzoszillatorschaltung, wobei die Quarzresonatoren jeweils eine parabolische, aber untereinander verschiedene Temperaturabhängigkeit besitzen, bei dem in einer Temperaturkompensationsschaltung die Frequenzen beider Oszillatorschaltungen derart verknüpft werden, dass innerhalb eines vorgegebenen Temperaturbereiches eine von der Temperatur unabhängige Ausgangsfrequenz entsteht.

Ein solcher Quarzoszillator wird in der GB-A-2 004 155 vorgeschlagen und beschrieben. Dabei werden zwei Niederfrequenzresonatoren mit der für Uhrenschaltungen üblichen Frequenz von 32 kHz mit verschiedenen quadratischen Temperaturkoeffizienten und gleichen Inversionstemperaturen verwendet.

Aus dem Vortrag in Proceedings of the 32nd Annual Symposium on Frequency Control, 31.5.-2.7.1978, Seiten 403-408 ist es ebenfalls für zwei Niederfrequenzquarzoszillatoren mit der für Uhrenschaltungen üblichen Frequenz von 32 kHz bereits bekannt, die parabolische Temperaturabhängigkeit der beiden Resonatoren so zu wählen, daß ein absteigender Ast der relativen Frequenzänderung des einen Resonators durch den Temperaturinversionspunkt der relativen Frequenzänderung des anderen Resonators geht.

Während die Temperaturkompensation mit einem zweiten Quarzresonator bei solchen Schaltungen genauer sein kann als bei der Verwendung anderer Komponenten wie Kondensatoren, Widerstände oder Halbleiter, liegt es in der Natur von Niederfrequenzresonatoren, dass ihre Alterung beträchtlich ist, wodurch längerfristig die erzielte Verbesserung herabgesetzt wird.

Es ist daher das Ziel des vorliegenden Erfindung, einen Oszillator mit Temperaturkompensation anzugeben, der einer wesentlich geringeren Alterung unterworfen ist und eine höhere Frequenzstabilität aufweist. Dieses Ziel wird durch einen in den Ansprüchen beschriebenen Oszillator erreicht.

Die Erfindung wird nun im einzelnen anhand eines Ausführungsbeispiels näher erläutert werden.

Figur 1  zeigt das parabolische Temperaturverhalten eines Hochfrequenzresonators nach Teilung seiner Frequenz,

Figur 2  zeigt das parabolische Temperaturverhalten eines Niederfrequenzresonators,

Figur 3  zeigt das parabolische Temperaturverhalten der Resonatoren nach den Figuren 1 und 2 in einer bestimmten Einstellung,

Figur 4  zeigt eine Temperaturkompensations-Schaltung, und

Figur 5  zeigt eine digitale Temperaturkompensations-Schaltung.

Es ist bekannt, dass bei Verwendung von Hochfrequenzresonatoren mit einer Frequenz von 4,2 MHz, mit einem bestimmten Schnitt wie nach beispielsweise US-A-4 071 797, die Alterung wesentlich geringer ist als bei Niederfrequenzresonatoren, so dass eine Temperaturkompensation und eine Frequenzbestimmung, bei denen der Hochfrequenzresonator bestimmend ist, bessere Kurzzeit- und insbesondere auch bessere Langzeiteigenschaften aufweisen.

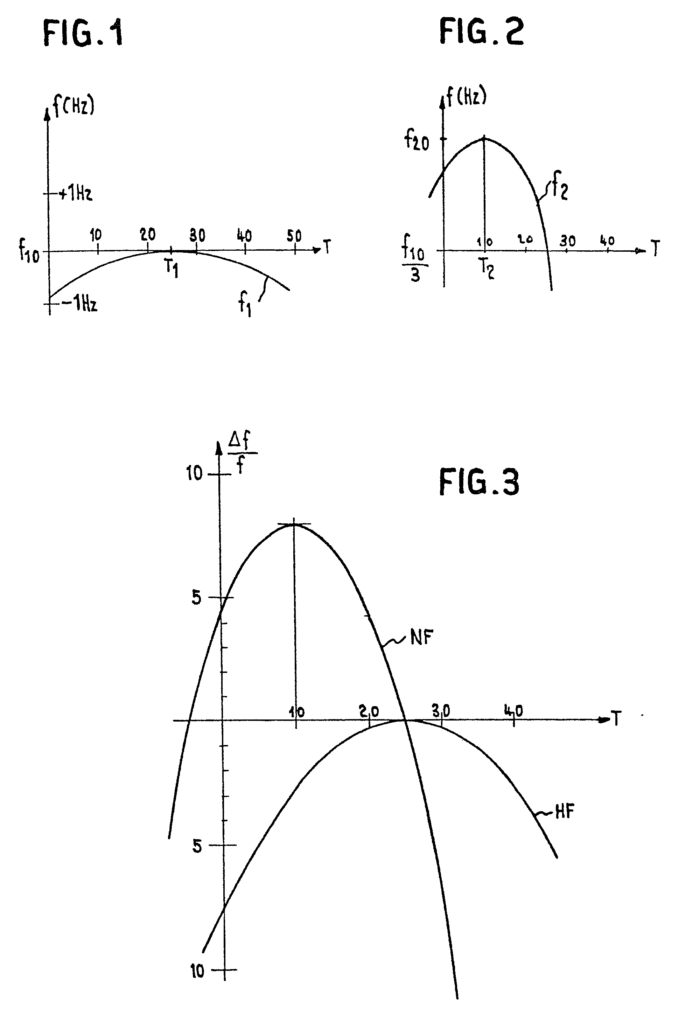

In Figur 1 ist das parabolische Temperaturverhalten des oben erwähnten Hochfrequenzresonators nach Teilung auf 96 kHz und in Figur 2 das parabolische Temperaturverhalten eines herkömmlichen Niederfrequenzresonators mit einer Frequenz von 32 kHz dargestellt.

Dabei gilt :

$$f_1(T) = f_{10}(1 + \beta_1(T - T_1)^2) + \gamma(T - T_1)^3)$$

und

$$f_2(T) = f_{20}(1 + \beta_2(T - T_2)^2)$$

wobei

$T_1$, $T_2$ die Inversionstemperaturen,

$f_{10}$, $f_{20}$ die Sollfrequenzen bei den Inversionstemperaturen und $\beta_1 = -1,2 \cdot 10^{-8}/(°C)^2$ der quadratische oder parabolische Temperaturkoeffizient für den Hochfrequenzresonator und

$\beta_2 = -3,6 \cdot 10^{-8}/(°C)^2$ der parabolische Temperaturkoeffizient des Niederfrequenzquarzes sind und $\gamma$ der kubische Temperaturkoeffizient ist.

Für die nachfolgende Beispielsangabe wird der Einfluss von $\gamma$ vernachlässigt.

Um die erfindungsgemässe Temperaturkompensation durchzuführen, werden die Resonatoren gemäss Figur 3 derart eingestellt, dass der eine Ast der relativen Frequenzänderung des Niederfrequenzresonators durch den Temperaturinversionspunkt ($T_1$) der relativen Frequenzänderung des Hochfrequenzresonators geht, das heisst, dass

$$f_1(T_1) = 3 \cdot 2^{15} \text{ Hz (96 kHz)}$$

und

$$f_2(T_1) = 2^{15} \text{ Hz (32 kHz)}$$

sind.

Das bedeutet mit anderen Worten, dass sich $f_1 : f_2$ wie $\beta_2 : \beta_1$ verhalten müssen. Dies folgt aus der Bedingung, dass $f_1 - f_2$ keine quadratische Temperaturabhängigkeit aufweisen soll. Rechnet man gemäss obigen Gleichungen diese Differenz aus, ergibt sich für das quadratische Temperaturglied

$$(f_{10}\beta_1 - f_{20}\beta_2)T^2 = 0.$$

Daraus folgt $f_{10}/f_{20} = \beta_2/\beta_1$ und somit $f_1 = 3f_2$.

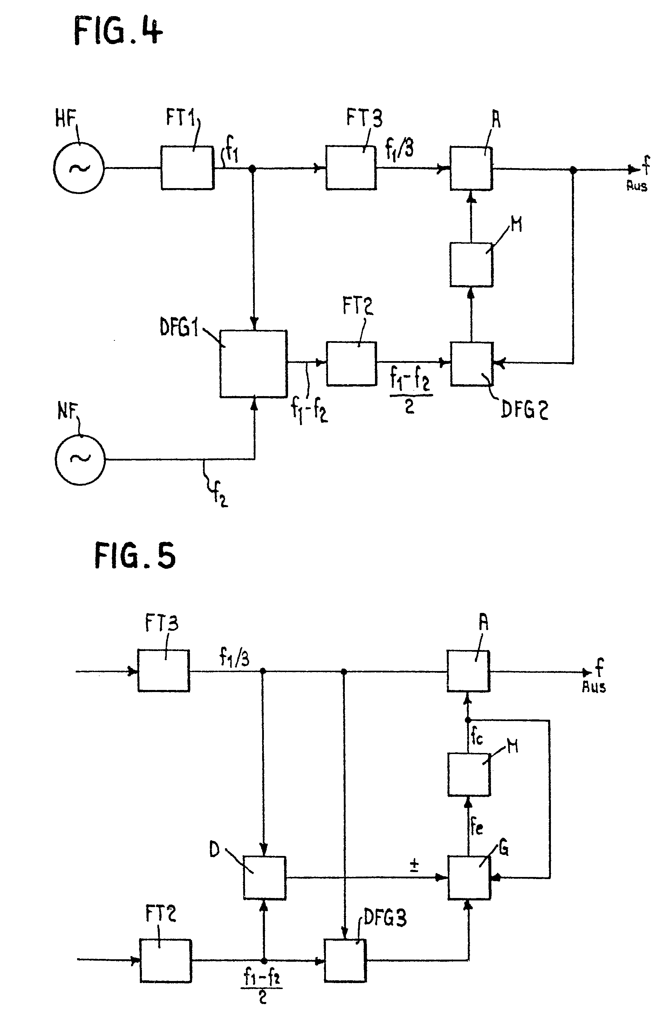

Ausgehend von den beiden derart eingestellten Resonatoren ist es die Aufgabe der Temperaturkompensationsschaltung von Figur 4 die Ausgangsfrequenzen $f_1$ und $f_2$ beider Resonatoren derart zu verknüpfen, dass eine von der Temperatur unabhängige Ausgangsfrequenz f entsteht. Die Frequenz $f_1$ von 96 kHz wird von einem ersten Frequenzteiler FTI eingestellt, während die Differenzfrequenz $f_1 - f_2 = 64$ kHz in einem ersten Differenzfrequenzgenerator DFGI erzeugt und im Frequenzteiler FT2 halbiert wird.

In einem anderen Frequenzteiler FT3 wird $f_1$ auf 32 kHz herabgesetzt, wobei diese Frequenz, $f_1/3$, die vom Hochfrequenzresonator stammt, die unkorrigierte Ausgangsfrequenz liefert. Anschliessend wird in einem weiteren Differenzfrequenzgenerator DFG2 die Differenz zwischen $f_1 - f_2/2$ und der rückgekoppelten

Ausgangsfrequenz f gebildet und anschliessend in der Schaltung M quadriert und mit einem konstanten Faktor k multipliziert und anschliessend in einer Additionsschaltung A zu der Frequenz $f_1/3$ addiert, um schliesslich eine Ausgangsfrequenz

$$f = \frac{f_1}{3} + k\left[\frac{f_1 - f_2}{2} - f\right]^2$$

zu ergeben.

Die Rückkoppelung und Subtraktion der temperaturunabhängigen Ausgangsfrequenz f von der halbierten Differenzfrequenz ergibt eine Frequenz, die linear von der Temperatur abhängt und dessen Wert bei der Inversionstemperatur $T_1$ 0 Hz beträgt.

Für f ergibt sich

$$f = \frac{f_1 - f_2}{2} + \frac{1}{\cdot 2k} \pm \frac{\sqrt{2k(f_1/3 - f_2) + 1}}{2k}$$

oder, da nur das Minuszeichen gelten kann

$$f = \frac{f_1 - f_2}{2} + \frac{1 - \sqrt{1 + 2k(f_1/3 - f_2)}}{2k}$$

Damit f temperaturunabhängig wird, muss k in diesem Beispiel den folgenden Wert annehmen

$$k = \frac{(\beta_1 - \beta_2)3}{2\,f_{10}\beta_2{}^2\,(T1 - T2)^2}$$

Setzt man in die Gleichungen die bereits angegebenen Werte ein ersieht man, dass einerseits der Einfluss des Korrekturgliedes sehr gering ist, so dass die vom Hochfrequenzresonator stammende Frequenz bestimmend bleibt und anderseits, dass die Ausgangsfrequenz temperaturunabhängig geworden ist.

Bei der digitalen Temperaturkompensation kann es vorkommen, dass bei der direkten Rückkopplung der Ausgangsfrequenz diese Schleife blockiert wird.

Wird daher die Temperaturkompensation in digitaler Form vorgenommen ist es vorteilhaft, wie in Fig. 5 dargestellt, schon die aus der Schaltung M kommende Korrekturfrequenz $f_c$ rückzukoppeln. Die gemäss Schaltung nach Fig. 5 erzielte Temperaturkompensation ist die gleiche wie im vorhergehenden Ausführungsbeispiel, denn

$$f = \frac{f_1}{3} + f_c \quad \text{und}$$

$$f_e = \frac{f_1 - f_2}{2} - f = \frac{f_1 - f_2}{2} - \left[\frac{f_1}{3} + f_c\right] = \frac{f_1 - f_2}{2} - \frac{f_1}{3} - f_c$$

3

Die Subtraktion wird also in zwei Schritten vorgenommen. Zuerst wird die aus dem Frequenzteiler FT3 stammende Frequenz $f_{1/3}$ von der aus dem Frequenzteiler FT2 stammenden Frequenz $f_1 - f_2/2$ im Differenzfrequenzgenerator DFG3 subtrahiert und diese Differenz gelangt in den Generator G, in welchem die rückgekoppelte Korrekturfrequenz $f_c$ entweder subtrahiert oder addiert wird.

Dies hängt davon ab, ob der Absolutwert der Differenz beider genannten Frequenzen grösser oder kleiner Null ist, das heisst

$$f_e = \left| \frac{f_1 - f_2}{2} - \frac{f_1}{3} \right| - f_c, \text{ wenn } \frac{f_1 - f_2}{2} - \frac{f_1}{3} > 0$$

$$f_e = \left| \frac{f_1 - f_2}{2} - \frac{f_1}{3} \right| + f_c, \text{ wenn } \frac{f_1 - f_2}{2} - \frac{f_1}{3} < 0$$

Das Vorzeichen wird durch den Diskriminator D festgestellt, der ein entsprechendes Signal an den Generator abgibt.

Der Ausgang von Generator G gelangt in die Schaltung M mit der bereits beschriebenen Funktion, von wo das Signal zur Additionsschaltung A gelangt, dort zu $f_1/3$ addiert wird, um schliesslich die gewünschte Ausgangsfrequenz f zur ergeben. Auch hier ist durch geeignete Massnahmen vorzusehen, dass die Rückkopplungsschleife nicht blockiert wird.

Das Vorzeichen aus dem Diskriminator D kann auch dazu benutzt werden, um den Koeffizienten k in gewissen Grenzen zu ändern, so dass man in erster Näherung den Einfluss des Gliedes 3. Ordnung, γ, korrigieren kann.

Die obigen Gleichungen können selbstverständlich sinngemäss für andere Werte verallgemeinert und verwertet werden.

Infolge des höheren Stromverbrauchs des Hochfrequenzresonators in Bezug auf einen Niederfrequenzresonator kann bei den zurzeit erhältlichen Batterien ihr häufigeres Wechseln erforderlich sein, und es besteht daher das Bestreben, den Stromverbrauch herabzusetzen. In der EP-Anmeldung 0 015 873 der gleichen Anmelderin ist eine Schaltung angegeben, in welcher der Hochfrequenzresonator nur periodisch angeschaltet wird, so dass der Stromverbrauch des gesamten Systems nur wenig über demjenigen eines Niederfrequenzoszillators liegt. Es ist nun, ausgehend von der vorliegenden Schaltung und von derjenigen der älteren Anmeldung für einen Fachmann möglich, eine Kombination anzugeben, worin ein Hochfrequenz- und ein Niederfrequenzresonator eine nahezu temperaturunabhängige Frequenz erzeugen und der Hochfrequenzresonator nur periodisch angeschaltet ist, um den Stromverbrauch stark herabzusetzen. Auch bei dieser kombinierten Schaltung ist der Hochfrequenzresonator mit seinen bezüglich Frequenzstabilität und Alterung wesentlich besseren Eigenschaften das bestimmende Element, während der negative Einfluss des anderen Resonators sehr gering bleibt.

Die Erfindung beschränkt sich nicht auf die hier angegebenen Werte von 32 kHz einerseits und 4, 2 MHz andererseits ; es können auch Resonatoren mit anderen Frequenzen verwendet werden, wobei die Gleichungen sinngemäss angewendet werden.

Der vorliegend beschriebene Oszillator kann überall dort, wo eine hohe Genauigkeit und ein günstiges Temperatur- und Langzeitverhalten erwünscht ist, und wo das dafür verfügbare Volumen klein ist, verwendet werden. Dies trifft beispielsweise bei einer Armbanduhr oder bei einer Filmkamera zu.

**Ansprüche**

1. Quarzoszillator mit einer ersten Quarzoszillatorschaltung und einer zweiten Quarzoszillatorschaltung, wobei die Quarzresonatoren jeweils eine parabolische, aber untereinander verschiedene Temperaturabhängigkeit besitzen, bei dem in einer Temperaturkompensationsschaltung die Frequenzen beider Oszillatorschaltungen derart verknüpft werden, dass innerhalb eines vorgegebenen Temperaturbereiches eine von der Temperatur unabhängige Ausgangsfrequenz entsteht, dadurch gekennzeichnet, dass einer der Quarzoszillatoren ein Hochfrequenzoszillator (HF) mit einem Hochfrequenzquarzresonator und der andere Quarzoszillator ein Niederfrequenzoszillator (NF) mit einem Niederfrequenzquarzresonator ist, deren parabolische Temperaturabhängigkeit jeweils derart gewählt ist, dass ein absteigender Ast der relativen Frequenzänderung (Δf/f (NF)) des Niederfrequenzresonators (NF) durch den Temperaturinversionspunkt ($T_1$) der relativen Frequenzänderung (Δf/f (HF)) des Hochfrequenzresonators (HF) geht, und dass die Temperaturkompensationsschaltung derart ausgelegt ist, dass der Hochfrequenzresonator zeitbestimmend ist.

2. Oszillator nach Anspruch 1, dadurch gekennzeichnet, dass der Hochfrequenzresonator (HF) eine Schwingungsfrequenz von 4,2 MHz und der Niederfrequenzresonator (NF) eine Schwingungsfrequenz

4

von 32 kHz aufweist.

3. Oszillator nach Anspruch 1 oder 2, dadurch gekennzeichnet, dass die Kompensationsschaltung Mittel (FT1), um die Frequenzen der beiden Resonatoren im umgekehrt proportionalen Verhältnis der quadratischen Temperaturkoeffizienten ($\beta_1$, $\beta_2$) einzustellen, gefolgt von einem Differenzfrequenzgenerator (DFG1), und weitere Mittel (FT2, FT3), um zwei im wesentlichen gleiche Frequenzen ($f_1 - f_2/2$, $f_1/3$) zu erhalten, und einen zweiten Differenzfrequenzgenerator (DFG2), um die rückgekoppelte Ausgangsfrequenz (f) von der Vergleichsfrequenz ($f_1 - f_2)/2$ zu subtrahieren und eine anschliessende Multiplikatorschaltung (M), um die Frequenz aus dem zweiten Differenzfrequenzgenerator (DFG2) zu quadrieren und mit einer Konstanten k zu multiplizieren und eine daran anschliessende Additionsschaltung (A), in welcher die aus der Multiplikatorschaltung stammende Frequenz zu der vom Frequenzteiler (FT3) stammende Frequenz ($f_1/3$) addiert wird, um eine temperaturkompensierte Ausgangsfrequenz (f) zu ergeben, aufweist.

4. Oszillator nach Anspruch 1 mit digitaler Temperaturkompensation, dadurch gekennzeichnet, dass die Kompensationsschaltung Mittel (FT1), um die Frequenzen der beiden Resonatoren im umgekehrt proportionalen Verhältnis der quadratischen Temperaturkoeffizienten ($\beta_1$, $\beta_2$) einzustellen, gefolgt von einem Differenzfrequenzgenerator (DFG1), und weitere Mittel (FT2, FT3), um zwei im wesentlichen gleiche Frequenzen ($f_1 - f_2/2$, $f_1/3$) zu erhalten, und einen weiteren Differenzfrequenzgenerator (DGF3) um die beiden im wesentlichen gleichen Frequenzen voneinander zu subtrahieren, gefolgt von einem Generator (G), in welchem das aus der nachfolgenden Multiplikatorschaltung (M) stammende Signal ($f_c$) gesteuert von einem Diskriminator (D), entweder von der aus dem weiteren Differenzfrequenzgenerator (DFG3) stammenden Frequenz subtrahiert oder zu dieser addiert wird und eine anschliessende Additionsschaltung (A), in welcher die aus der Multiplikatorschaltung stammende Frequenz zu der vom Frequenzteiler (FT3) stammenden Frequenz ($f_1/3$) addiert wird, um eine temperaturkompensierte Ausgangsfrequenz (f) zu ergeben, aufweist.

5. Oszillator nach einem der Ansprüche 1-4, dadurch gekennzeichnet, dass er zwecks Erniedrigung des Stromverbrauchs eine Schaltung aufweist, um den Hochfrequenzresonator periodisch einzuschalten.

## Claims

1. Quartz crystal oscillator with a first quartz crystal oscillator circuit and a second quartz crystal oscillator circuit in which the quartz crystal resonators exhibit between themselves a different parabolic dependance on temperature, the frequencies of both oscillator circuits being combined into a temperature compensating circuit so that within a predetermined range of temperature an output frequency independant from the temperature is produced, characterized in that one of the quartz crystal oscillators is a high frequency oscillator (HF) with a high frequency resonator and that the other quartz crystal oscillator is a low frequency oscillator (NF) with a low frequency resonator, the parabolic dependances on the temperature being respectively so selected that a descending branch of the relative variation of frequency ($\Delta f/f$ (NF)) of the low frequency resonator (NF) crosses the point of temperature inversion (T1) of the relative variation of frequency ($\Delta f/f$ (HF)) of the high frequency resonator (HF) and in that the temperature compensating circuit is so designed that the high frequency resonator determines the time.

2. Oscillator according to claim 1, wherein the high frequency resonator (HF) has a frequency of 4.2 MHz and the low frequency resonator (NF) a frequency of 32 kHz.

3. Oscillator according to claim 1 or 2, wherein the temperature compensating circuit comprises means (FT1) for adjusting the frequencies of both resonators so that the ratio of said frequencies is inversely proportional to the quadratic temperature coefficients ($\beta_1$, $\beta_2$), said means being followed by a beat frequency generator (DFG1), the temperature compensating circuit further comprising means (FT2, FT3) for producing two substantially equal frequencies ($f_1 - f_2/2$, $f_1/3$), a second beat frequency generator (DFG2) for subtracting the feedback output frequency (f) from the frequency of comparison ($f_1 - f_2/2$), a multiplier circuit (M) connected to said second beat frequency generator for raising to the power two and multiplying by a constant k the frequency of said second beat frequency generator and an adding circuit (A) connected to said multiplier circuit for adding the frequency delivered by the multiplier circuit to the frequency ($f_1/3$) provided by a frequency divider (FT3) for producing a temperature compensated output frequency (f).

4. Oscillator according to claim 1, with digital temperature compensation, wherein the temperature compensating circuit comprises means (FT1) for adjusting the frequencies of both resonators so that the ratio of said frequencies is inversely proportional to the quadratic temperature coefficients ($\beta_1$, $\beta_2$), said means being followed by a beat frequency generator (DFG1), the temperature compensating circuit further comprising means (FT2, FT3) for producing two substantially equal frequencies ($f_1 - f_2/2$, $f_1/3$), a second beat frequency generator (DFG3) for subtracting the two substantially equal frequencies from each other followed by a generator (G) in which the signal ($f_c$) provided by a multiplier circuit (M) connected to the output of the generator (G) is either subtracted or added to the frequency of the beat frequency generator (DFG3) in response to the control of a discriminator (D), said multiplier circuit being connected to an adding circuit (A) in which the frequency from the multiplier circuit is added to the

frequency ($f_1/3$) of a frequency divider (FT3) for producing a temperature compensated output frequency (f).

5. Oscillator according to one of the claims 1-4, comprising a circuit for periodically switching on the high frequency resonator for decreasing the current consumption.


## Revendications

1. Oscillateur à quartz avec un premier circuit oscillateur à quartz et un second circuit oscillateur à quartz dans lesquels les résonateurs à quartz ont entre eux une dépendance parabolique différente de la température, les fréquences des deux circuits oscillateurs étant combinées dans un circuit de compensation en température de manière qu'à l'intérieur d'un domaine de température prédéterminé il se produise une fréquence de sortie indépendante de la température, caractérisé par le fait que l'un des oscillateurs à quartz est un oscillateur à haute fréquence (HF) avec un résonateur à haute fréquence et que l'autre oscillateur à quartz est un oscillateur à basse fréquence (NF) avec un résonateur à basse fréquence, les dépendances paraboliques de la température étant choisies respectivement de manière qu'une branche descendante de la variation relative de fréquence ($\Delta f/f$ (NF)) du résonateur à basse fréquence (NF) passe par le point d'inversion de température (T1) de la variation relative de fréquence ($\Delta f/f$ (HF)) du résonateur à haute fréquence (HF) et par le fait que le circuit de compensation de température est agencé de manière que le résonateur à haute fréquence détermine le temps.

2. Oscillateur selon la revendication 1, caractérisé par le fait que le résonateur à haute fréquence (HF) a une fréquence de 4,2 MHz et que le résonateur à basse fréquence (NF) a une fréquence de 32 kHz.

3. Oscillateur selon la revendication 1 ou 2, caractérisé par le fait que le circuit de compensation comprend des moyens (FT1) pour ajuster les fréquences des deux résonateurs dans un rapport inversément proportionnel aux coefficients de température quadratiques ($\beta_1$, $\beta_2$), lesdits moyens étant suivis d'un générateur de fréquence de différence (DFG1), d'autres moyens (FT2, FT3) pour obtenir deux fréquences substantiellement égales ($f_1 - f_2/2$, $f_1/3$), un second générateur de fréquence de différence (DFG2) pour soustraire la fréquence de sortie réinjectée (f) de la fréquence de comparaison ($f_1 - f_2/2$), un circuit multiplicateur (M) relié au second générateur de fréquence de différence pour élever au carré la fréquence dudit second générateur (DFG2) et la multiplier par une constante k et un circuit d'addition (A) relié audit circuit multiplicateur pour ajouter la fréquence délivrée par le circuit multiplicateur à la fréquence ($f_1/3$) provenant d'un diviseur de fréquence (FT3) pour produire une fréquence de sortie (f) compensée en température.

4. Oscillateur selon la revendication 1 avec compensation digitale de la température, caractérisé par le fait que le circuit de compensation comprend des moyens (FT1) pour ajuster les fréquences des deux résonateurs dans un rapport inversément proportionnel aux coefficients de température quadratiques ($\beta_1$, $\beta_2$), lesdits moyens étant suivis d'un générateur de fréquence de différence (DFG1), d'autres moyens (FT2, FT3) pour obtenir deux fréquences substantiellement égales ($f_1 - f_2/2$, $f_1/3$), un second générateur de fréquence de différence (DFG3) pour soustraire l'une de l'autre les deux fréquences substantiellement égales, suivi d'un générateur (G) dans lequel le signal ($f_c$) provenant d'un circuit multiplicateur (M) relié à la sortie du générateur (G) est soit soustraite soit ajoutée à la fréquence du générateur de fréquence de différence (DFG3) en réponse à la commande d'un discriminateur (D), le circuit multiplicateur étant relié à un circuit d'addition (A) dans lequel la fréquence provenant du circuit multiplicateur est ajoutée à la fréquence ($f_1/3$) d'un diviseur de fréquence (FT3) pour produire une fréquence de sortie (f) compensée en température.

5. Oscillateur selon l'une des revendications 1-4, caractérisé par le fait qu'il comprend un circuit permettant d'enclencher périodiquement le résonateur à haute fréquence pour diminuer la consommation de courant.

# FIG. 1

# FIG. 2

# FIG. 3

# FIG.4

# FIG.5